# EUROPÄISCHE PATENTSCHRIFT

(11) **EP 2 439 075 B1**
(45) Veröffentlichungstag und Bekanntmachung des Hinweises auf die Patenterteilung: **11.12.2013**
(21) Anmeldenummer: 11183850.4
(22) Anmeldetag: 04.10.2011
(51) Int. Cl.: B42B 4/00, G01R 33/09

(54) **Vorrichtung für die durchlaufende Qualitätskontrolle von applizierten Teilen**
Device for continuous quality control of applied parts
Dispositif de contrôle de la qualité en continu de pièces appliquées

(30) Priorität: 08.10.2010 CH 16512010
(43) Veröffentlichungstag der Anmeldung: 11.04.2012
(73) Patentinhaber: Müller Martini Holding AG, 6052 Hergiswil (CH)
(72) Erfinder: Schenker, Thomas, 4800 Zofingen (CH); Von Aesch, Beat, 5012 Schönenwerd (CH); Liebi, Thomas, 4852 Rothrist (CH)
(74) Vertreter: Liebe, Rainer

(56) Entgegenhaltungen:
- EP-A1- 1 591 272
- WO-A1-00/17863
- DE-A1-102007 029 819

## Beschreibung

### Technisches Gebiet

Die vorliegende Erfindung betrifft ein Verfahren für die durchlaufende Qualitätskontrolle eines applizierten Teils hinsichtlich seiner geometrischen, strukturellen, funktionellen Parameter gemäss Anspruch 1. Die Erfindung betrifft auch eine Messeinrichtung zur Durchführung des Verfahrens.

### Stand der Technik

Druckprodukte werden bekanntlich vielfach mit Klammern geheftet, wobei zu diesem Zweck eine Drahtheftvorrichtung verwendet wird. Drahtheftvorrichtungen weisen jeweils einen Heftkopf und einen Umbieger auf, mit denen der Heftvorgang durchgeführt wird. Dieser Heftvorgang umfasst das Zuführen eines Drahtes, das Abschneiden eines Rohlings, die Klammerformung, das Durchstechen des zu heftenden Produktes und das Umbiegen der beiden Klammerschenkel.

Es sind zudem im Stand der Technik Verfahren und Vorrichtungen bekannt, mit denen das Vorhandensein einer Heftklammer an einem Produkt geprüft werden kann. Dies soll es ermöglichen, ein Produkt mit einer fehlenden Heftklammer auszuschleusen. Eine solche Prüfung erfolgt beispielsweise mit einem Metalldetektor, der in Transportrichtung im Nachgang zu der Drahtheftvorrichtung angeordnet ist. Jede durchlaufende Heftklammer löst einen Impuls aus. Ein fehlender Impuls ist ein Hinweis auf ein Produkt mit einer fehlenden Heftklammer.

Weiter ist durch die EP 0 205 144 eine Vorrichtung bekannt geworden, bei welcher eine fehlende Heftklammer mit einem Sensor ermittelt wird, der an einem Heftapparat angeordnet ist. Der Sensor besteht aus einem Näherungsschalter oder ist als optischer Sensor ausgebildet.

Bei den oben erwähnten Verfahren und Vorrichtungen kann jedoch lediglich die Anwesenheit und nicht die Qualität einer Heftung geprüft werden. Es werden somit auch Heftklammern als vorhanden resp. angebracht angezeigt, die defekt sind und beispielsweise einen abstehenden Schenkel aufweisen. Solche defekte Heftungen sind sehr unerwünscht, da sie zu Verletzungen des Benutzers bzw. Lesers eines solchen Druckproduktes führen können. Es sind im Stand der Technik deshalb bereits zahlreiche Massnahmen vorgeschlagen worden, mit denen solche defekte Heftungen festgestellt und die entsprechenden Druckprodukte ausgeschleust werden können.

So ist aus der EP 1 029 443 A eine Vorrichtung zur Kontrolle der Heftung von Produkten bekannt geworden, bei welcher an der Drahtheftvorrichtung Messmittel angeordnet sind, mit denen Zustandsänderungen eines Umbiegers oder eines die Klammern durchtreibenden Heftkopfes der Drahtheftvorrichtung ermittelt werden. Diese Mittel sind beispielsweise als Dehnmessstreifen ausgebildet. Mit diesen wird die Kraft ermittelt, welche bei der Bildung der Heftklammer am Umbieger auftreten. Weicht die Kraft von einem vorbestimmten Wert ab, so wird angenommen, dass die Heftung fehlerhaft ist und entsprechend wird das Produkt über die Maschinensteuerung ausgeschleust. Geprüft wird hier somit der Heftvorgang in der Drahtheftvorrichtung. Rückschlüsse auf die effektive Verarbeitung der Heftklammer sind damit nicht gegeben.

Des Weiteren ist nach EP 1 591 272 A1 ein Verfahren bekannt geworden, bei welchem die Messmittel jeweils den Dichteverlauf an einer durchlaufenden Heftklammer prüfen. Bei defekten Klammern, bei denen beispielsweise ein Schenkel vorsteht oder fehlt, weicht der Dichteverlauf wesentlich von demjenigen einer fehlerfreien Heftklammer ab. Bei einer solchen fehlerfreien Heftklammer sind die beiden Schenkel vorhanden und wie vorgesehen umgebogen, so dass sie üblicherweise keine Gefahr für eine Verletzung bilden. Mit diesem Verfahren können aber auch andere Defekte einer Heftung ermittelt werden. Dies ist beispielsweise auch dann möglich, wenn die Klammer eine sogenannte Ösenheftklammer darstellt, und bei dieser die Öse defekt, beispielsweise verbogen ist. Diese qualitätssichernde Kontrolle ist wesentlich davon abhängig, wie sich der Auflösungsgrad des eingesetzten Sensors insbesondere im Betrieb verhält.

Aus DE 38 17 024 A1 ist ein Verfahren nach dem Oberbegriff des Anspruchs 1 zur Kontrolle von Drahtheftungen bekannt geworden, mit dem Ziel, die Qualität der bearbeiteten Gegenstände zu erhöhen und die Makulatur zu senken. Zu diesem Zweck wird aus einer Vielzahl von Messpunkten ein Signalbild von einer Drahtheftung eines Sollprodukts gewonnen und abgespeichert. Bei der Qualitätsprüfung wird ein punktweiser Vergleich mit Signalwerten der Drahtheftung der Istprodukte vorgenommen und die ausserhalb von vorgegebenen Toleranzgrenzen liegenden Differenzwerte zwischen Soll- und Istzustand als fehlerhafte Drahtheftung signalisiert. Bei dieser Druckschrift fällt auf, dass die Mittel zur Umsetzung der hier beschriebenen Stossrichtung summarisch benannt werden. So ist hier lediglich zum Stand der Technik die Rede, dass für die metallischen Gegenstände ein induktiver Fühler verwendet wird. Später ist nur noch von einem Sensor die Rede.

EP-A-1591272 offenbart ein Verfahren mit einer Messeinrichtung mit einem Messkopf mit Spule und Oszillator.

So ergeben sich zum Stand der Technik die folgenden Erkenntnisse:

Wird zur Ermittlung des geometrischen Zustandes der Heftklammer eine Spule eingesetzt, so erweist sich diese als zu gross, so dass eine Nährung zum Objekt zu einer besseren Auflösung erschwert bleibt.

Auch der Weg über eine Induktivspule hat nicht den gewünschten Erfolg gebracht, obwohl durch die verhältnismässige Miniaturisierung der Spule gewisse Verbesserungen erzielt werden konnten, deswegen konnte aber die gewünschte Auflösung trotzdem noch nicht erreicht werden.

Der Grad der Auflösung wird also weitgehend durch die physikalischen Grenzen des eingesetzten Sensors vorgegeben.

### Darstellung der Erfindung

Hier will die Erfindung Abhilfe schaffen. Der Erfindung, wie sie in den Ansprüchen gekennzeichnet ist, liegt die Aufgabe zugrunde, bei einem Verfahren und einer Vorrichtung der eingangs genannten Art Mittel vorzuschlagen, welche eine bessere Auflösung der zu messenden oder zu detektierenden Konfiguration des applizierten Elementes erlaubt, und somit eine maximierte Qualitätssicherung gewährleistet. Grundsätzlich geht es hier darum, die Qualität des applizierten Elementes zu überprüfen, d.h. möglichst ein genaues Abbild dieses Elementes zu erhalten. Die erfassten elektronischen Abbilder der applizierten Elemente können einerseits dazu verwendet werden, um den Soll-Zustand solcher Elemente zu erfassen, also ein sogenanntes Referenz-Abbild herzustellen. Andererseits kann ein aktuelles erfasstes Abbild mit dem Referenz-Abbild verglichen werden, und durch die Auswertung der Abweichung lässt eine Gut/Schlecht-Auswertung durchführen.

Zu diesem Zweck wird ein Sensor-Modul, vorzugsweise mit einem integrierten Signalverstärker vorgeschlagen, welches aus einer Kombination mit mindestens einem Permanentmagnet und einem GMR-Sensor-Chips besteht. Dabei ist die betriebliche Umsetzung dieses Sensor-Moduls so gehalten, dass dieses möglichst nahe an dem vorbeifahrenden Element positioniert ist.

Der GMR-Effekt (Giant Magneto Resistance) wird in Strukturen beobachtet, die aus sich abwechselnden magnetischen und nicht magnetischen dünnen Schichten mit einigen Nanometern Schichtdicke bestehen. Mit diesen Strukturen können Messmittel (Sensor-Chips) gebaut werden, die ihre elektrische Leitfähigkeit auf Grund der magnetischen Feldstärke ändern.

Die Umsetzung dieser Erkenntnisse auf die Prüfung der qualitativen Vorgaben bei Heftklammern hat bis heute noch nicht stattgefunden, da in der Fachwelt die Meinung vertreten wurde, dass die zum Stand der Technik angebotenen Lösungen vollauf genügen würden, oder sich die Meinung durchgesetzt hat, dass durch die filigrane Gestaltung solcher Heftklammer und wegen der hohen Förderungstaktzahlen bei der Herstellung von mit Heftklammern gebundenen Druckprodukten ohnehin schwierig sei, bessere Lösungen vorzuschlagen.

Grundsätzlich ist es so, dass sich die feinen Strukturen bei Heftklammern auch bei anderen applizierbaren Elementen wiederfinden können, deren Qualität auch fortlaufend und bei hohen Taktzahlen integral überprüft werden muss, insbesondere wenn solche Elemente eine funktionale Wirkung gegenüber den Basisprodukt entfalten, und gerade diese Qualitätssicherung eine wesentliche Akzeptanz des Produkts selbst entfaltet.

Wenn also vorliegend die Anwendung der Erfindung für das bessere Verständnis der erfindungsgemässen Lösung auf Heftklammern fokussiert wird, soll dies keine präjudizielle Einschränkung gegenüber anderen applizierbaren Produkten entfalten. Indem hier die Fokussierung auf Heftklammern erfolgt, hängt damit zusammen, dass anhand dieser Anwendung die wesentlichen Aspekten der Erfindung umfassend dargelegt werden können.

Die Funktionsweise des erfindungsgemässen Sensor-Moduls ist die folgende:

Der Permanentmagnet erzeugt ein Magnetfeld im Bereich der vorbeifahrenden Heftklammer. Die hier weichmagnetische Heftklammer erzeugt dadurch als Reaktion selber ein Magnetfeld, das dem konstanten Feld des Permanentmagneten überlagert wird. Die GMR-Sensor-Chips messen die Feldstärken-Differenz an zwei nahe beieinander liegenden Punkten (Gradient) und liefern dabei ein entsprechendes analoges Spannungssignal, das Rückschluss auf die Form des magnetischen Feldes liefert. Abweichungen im Signalverlauf lassen Rückschlüsse auf die Qualität, d.h. auf den applizierten Zustand der Heftklammern oder allgemein der eingesetzten Elemente zu, und sollen dann für eine effiziente Detektierung des Istzustandes dieser Elemente dienen, wobei selbstverständlich die hier zugrunde liegende Qualitätstoleranz berücksichtigt wird.

Der wesentliche Vorteil der Erfindung ist somit darin zu sehen, dass sich durch die Miniaturisierung des GMR-Sensor-Chips grosse Freiheitsgrade gegenüber dem zu messenden oder zu detektierenden Element ergeben, welche die effektive integrale Erfassung dieses applizierten Elementes ermöglichen, gewichtig dadurch gegeben, dass der Messkopf auch unter erschwerten Bedingungen sehr nah an das Element herangeführt werden kann.

Ein weiterer wesentlicher Vorteil der Erfindung ist darin zu sehen, dass eine Kombination von mehreren GMR-Sensor-Chips vorgesehen werden kann, welche in Verbund miteinander eine genauere und aus mehreren Perspektiven gebildete Abbildung des an sich filigranen Elementes ermöglichen, wobei diese GMR-Sensor-Chips signaltechnisch auch so miteinander verbunden werden können, dass insbesondere einzelne Aspekte des detektierten Elementes gezielt hervorgehoben und danach abgebildet werden können, wobei es sich bei dieser Abbildung um eine magnetische Abbildung handelt.

Weitere vorteilhafte aufgabengemässe Ausführungsvarianten gehen aus den abhängigen Ansprüchen hervor.

### Kurze Beschreibung der Figuren

Nachstehend wird die Erfindung unter Bezugnahme auf die Zeichnung, auf die hinsichtlich aller erfindungswesentlichen und in der Beschreibung nicht näher herausgestellten Einzelheiten ausdrücklich Bezug genommen wird, erläutert. Alle für das unmittelbare Verständnis der Erfindung nicht wesentlichen Elemente sind weggelassen worden. Gleiche Elemente sind in den einzelnen Figuren mit den gleichen Bezugszeichen versehen. Es zeigt:
- Fig. 1: einen Querschnitt durch einen Messkopf, bei welchem auf einem Permanentmagneten seitlich zwei GMR-Sensor-Chips angeordnet sind;
- Fig. 2: eine Darstellung der Wirkungsweise des GMR.Sensor-Chips in Produktlaufrichtung,
- Fig. 3: das Messprinzip mit einem GMR-Sensor-Chip und
- Fig. 4: eine mögliche Anordnungen von GMR-Sensor-Chips.

### Ausführungsbeispiel der Erfindung, gewerbliche Anwendbarkeit

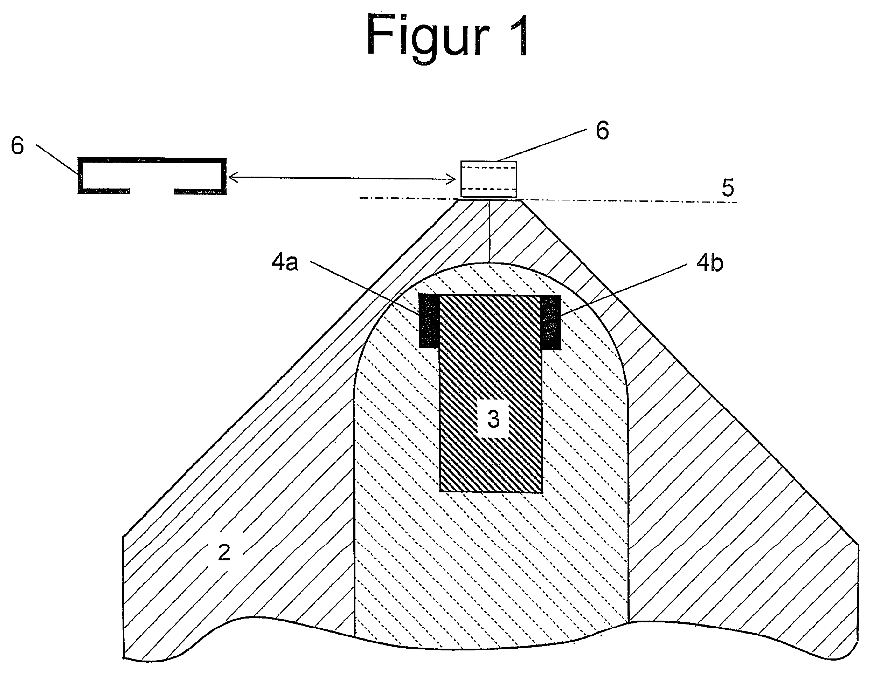

Fig. 1 zeigt die Anbringung eines Messkopfes 2 innerhalb einer Heftklammerstation 1. Der Messkopf 2 selbst besteht aus einem Permanentmagneten 3, der mit zwei GMR-Sensor-Chips 4a und 4b ergänzt ist. Diese zwei GMR-Sensor-Chips 4a, 4b sind seitlich auf dem Permanentmagneten 3 verankert. Oberhalb des Messkopfes 2 befindet sich die Ebene 5 der Heftklammern 6, welche von dem Messkopf 2 magnetisch abgebildet werden. Es ist zu berücksichtigen, dass bei Sammelheftern für bestimmte Druckprodukte Taktzahlen grösser 16'000 vorliegen. Daraus lässt sich verstehen, welche Anforderungen hier für eine qualitativ hochstehende Messung erfüllt sein müssen.

Der Permanentmagnet 3, vorzugsweise im Messkopf 2 eingegossen, erzeugt eine magnetische Anregung für die vorbeifahrende Heftklammer 6. Die hier weichmagnetische Heftklammer erzeugt dadurch als Reaktion selber ein Magnetfeld, das dem konstanten Feld des Permanentmagneten überlagert wird. Die GMR-Sensor-Chips 4a, 4b messen je die Feldstärken-Differenz an zwei nahe beieinander liegenden Punkten (Gradient) und liefern dabei ein entsprechendes analoges Spannungssignal, das Rückschluss auf die Form des magnetischen Feldes liefert. Abweichungen im Signalverlauf lassen Rückschlüsse auf die Qualität, d.h. auf den applizierten Zustand der Heftklammern 6 zu, und sollen dann für eine effiziente Detektierung von ausserhalb der Qualitätstoleranz liegenden Heftklammern 6 ausgenutzt werden. Die Magnetkraft wirkt auf die Heftklammer, und diese wird bei üblichem Material gegen den Permanentmagneten angezogen. Die Abbildung der Heftklammer über zwei Chips bedingt dann, dass bei fehlender absoluter Symmetrie eine mathematische Aufbereitung stattfinden muss.

Mit diesem Verfahren, unter Einschluss der durch den Messkopf 2 erzeugte magnetischen Abbildung, d.h. die Vermessung, wird die Heftklammer 6 in all ihren Komponenten erfasst, d.h.,
- ob die Heftklammer am richtigen Ort angebracht ist,
- ob die beiden Schenkel der Heftklammer eine gleichmässige und parallele Durchstossung der zu heftenden Druckprodukten aufweisen,
- ob die beiden Schenkel der Heftklammer gleichmässig umgebogen wurden,
- ob und die beiden Schenkel der Heftklammer bestimmungsgemäss umgebogen wurden, und sie gegenüber der inneren Falzung der Druckprodukte absolut flach anliegen, womit sie keine Gefahr für eine Verletzung bilden.

Darüber hinaus lassen sich mit diesem Messkopf 2 auch Informationen erzeugen, welche nicht nur auf die obigen konventionellen Heftklammern ausgerichtet sind, sondern ebenso gut sogenannte Ösenheftklammern erfassen können. Insbesondere bei dieser Prüfung und magnetischer Abbildung werden hohe Anforderungen gestellt, denn die Geometrie und Struktur einer Ösenheftklammer ist ungleich komplizierter aufgebaut, als dies bei einer konventionellen Heftklammer der Fall ist.

Der Messkopf 2 weist für die Messung und magnetische Abbildung ein hohes Weiterbildungspotential auf, indem zusätzliche GMR-Sensor-Chips eingebaut werden können, welche beispielsweise nur für Teilaspekte der Qualitätsprüfung zuständig sind. Der hohe Grad an Miniaturisierung des Messkopfes 2 ermöglicht des Weiteren, dass mehrere Messköpfe 2 hintereinander angeordnet werden können, und diese dann messtechnisch miteinander in Wirkverbindung stehen.

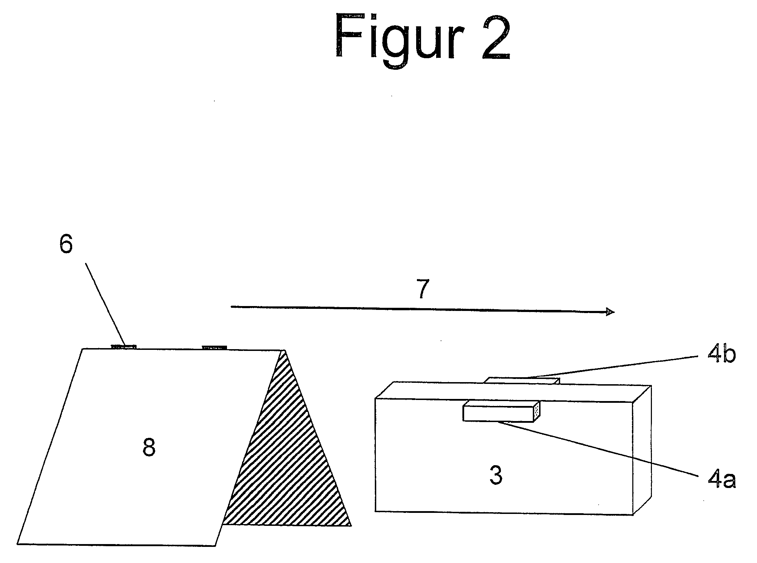

Fig. 2 zeigt die Vorgehensweise der hier zugrundeliegenden magnetischen Abbildung der angebrachten Heftklammern in Produktlaufrichtung 7. Die Grössenverhältnisse zwischen Druckbogen 8 und Messkopf 2 sind aber hier zu Gunsten des Messkopfes 2 stark überzeichnet und entsprechen in keiner Weise den effektiven Verhältnissen. Hierzu wird auf Fig. 1 verwiesen, in welcher die starke Annäherung des Messkopfes 2 an die Ebene der Heftklammer 6 hervorgeht.

Wie aus Fig. 2 hervorgeht, sind die GMR-Sensor-Chips 4a, 4b je auf beiden Seiten des Permanentmagneten angeordnet, wobei die Länge des Permanentmagneten in Laufrichtung der angebrachten Heftklammer steht. Im Idealfall durchläuft die Heftklammer die Länge des Permanentmagneten mittig zu den jeweils lateral angeordneten GMR-Sensor-Chips 4a, 4b. Diese weisen mindestens einen Messpunkt auf. Weisen die GMR-Sensor-Chips 4a, 4b jeweils zwei oder mehrere Messpunkte auf, so erfasst man mithin auch etwaige Verzerrungen allgemein im System. Es können auch pro Seite des Permanentmagneten zwei oder mehr hintereinander angeordnete GMR-Sensor-Chips 4a, 4b vorgesehen werden, welche auch mit einer untereinander differierenden Auflösung ausgebildet sind. Die GMR-Sensor-Chips 4a, 4b brauchen auch nicht symmetrisch zueinander angeordnet zu sein. Ziel bei der Festlegung der Lage der einzelnen GMR-Sensor-Chips 4a, 4b im Verhältnis zueinander bildet einerseits die Maximierung der Auflösung und andererseits die Detektierung des integralen geometrischen Zustandes der hier applizierten Heftklammer für die Erhaltung eines mehrdimensionalen Bildes. Dadurch, dass eine Flexibilisierung der Lage der GMR-Sensor-Chips 4a, 4b entlang und beidseitig des Permanentmagneten möglich ist, lässt sich damit erreichen, dass hinsichtlich der Quelle des Magnetfeldes mehrere Messpositionen entstehen, durch welche ein dreidimensionales Signal des applizierten Elementes, beispielsweise der hier beschriebenen Heftklammer, erfasst werden kann. Somit ist es möglich, insbesondere bei solchen Heftklammern auch ihre seitliche Verformung quer zur Laufrichtung aufzuzeigen.

Bei bestimmten Konfigurationen oder Konstellationen zwischen Messverfahren und Lage des Messkopfes 2 ist auch möglich, die Messelemente quer zur Laufrichtung anzuordnen.

Zusammenfassend lässt sich sagen, dass durch den Einsatz des hier beschriebenen Messkopfes 2 die qualitätsbezogenen Erkennungsquote des zu messenden oder zu detektierenden Elementes maximiert wird.

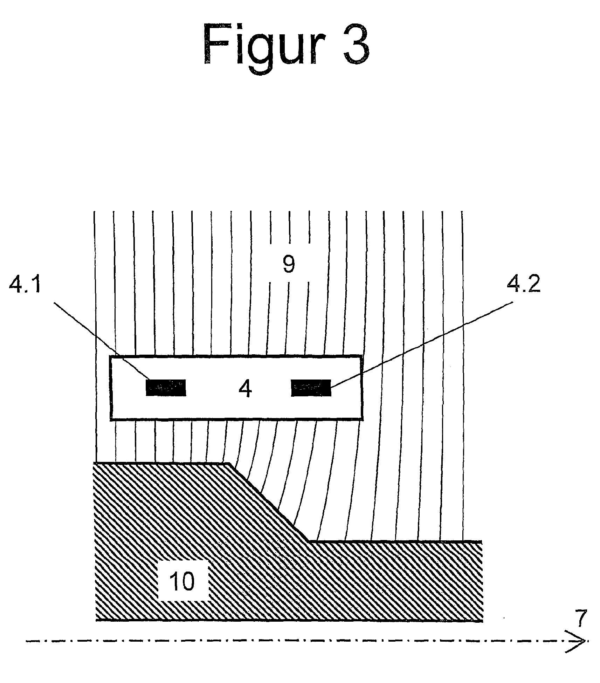

Figur 3 zeigt das Messprinzip mit einem GMR-Sensor-Chip: Der GMR-Sensor-Chip 4 besitzt zwei Messpunkte 4.1, 4.2, die in einer bestimmten Distanz zueinander angeordnet sind. Die Widerstandselemente auf dem GMR-Sensor-Chip, welche auf die magnetische Feldstärke 9 reagieren, sind zu einer Wheatstone-Brücke (Vollbrücke) verschaltet. Dies Widerstandsmessbrücke liefert ein Signal das proportional zum Gradienten der Feldstärke ist. Es handelt sich also um einen Gradientensensor, bzw. einen Magnetfelddifferenzsensor.

Es gibt verschiedene Ausführungen von GMR-Sensor-Chips, die sich im Wesentlichen durch den Abstand der Messpunkte unterschieden. Die Abstände sind optimiert zum Abtasten von sich wiederholenden Strukturen, wie sie üblicherweise bei Heftklammern vorhanden sind. Auch bei Wegmessung kommen solche Strukturen vor.

Bei unserem Prinzip wird angestrebt, die Struktur von weichmagnetischen Teilen, bzw. Heftklammern so genau abzubilden, dass Qualitätsabweichungen bezüglich der Form sicher detektieren werden können. Figur 3 zeigt wie das ursprünglich homogene Magnetfeld durch das vorbeifahrende weichmagnetische Element verzerrt wird. An den beiden Messpunkten a und b entsteht dadurch eine leicht unterschiedliche Feldstärke. Der GMR-Sensor-Chip liefert entsprechend der Feldstärkendifferenz ein dieser Differenz proportionales positives oder negatives Spannungssignal. Dieses Spannungssignal muss dann für die Auswertung elektronisch verstärkt werden.

Die GMR-Sensor-Chips werden in dieser Applikation in Kombination mit einem Stützmagneten (Permanentmagnet) eingesetzt, der ein statisches Magnetfeld erzeugt. Das (im Bereich der Messung) homogene Magnetfeld wird durch das sich vorbeibewegende weichmagnetische Element 10 verzerrt. Wie Fig. 3 zeigt, erzeugen vor allem Kanten und Flanken die grösste Verzerrung.

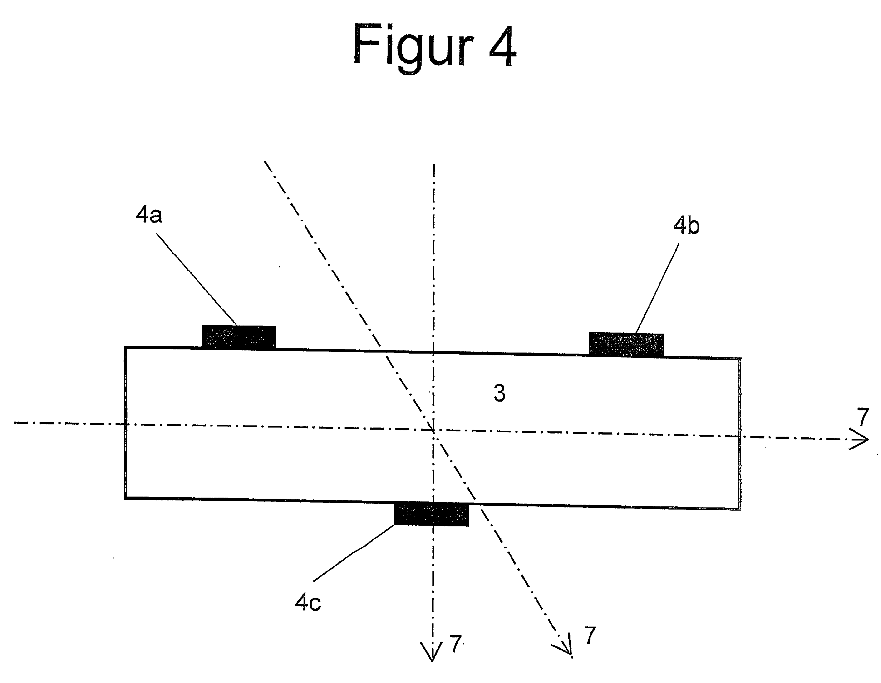

Figur 4 zeigt eine mögliche Anordnung von GMR-Sensor-Chips: Grundsätzlich kann ein Permanentmagnet mit einem oder mehreren GMR-Sensor-Chips 4a, 4b, 4c ausgerüstet werden. Die Sensor-Chips sollten aber vorzugsweise dort angebracht werden, wo das Magnetfeld in einer Ebene möglichst homogen ist, d.h. die Feldstärkendifferenz sollte im Ruhezustand gleich Null sein, d.h. ohne weichmagnetisches Element im Einflussbereich. Dies wird am besten erreicht bei einer Anordnung im mittleren Bereich einer Längskante. Die magnetische Feldstärke im Bereich des GMR-Sensor-Chips muss, entsprechend der Kennlinie des GMR-Sensor-Chips, so ausgelegt werden, dass ein optimaler Arbeitspunkt für den Sensor entsteht.

Die GMR-Sensor-Chips müssen bezüglich dem Permanentmagneten, als Quelle der magnetischen Anregung, eine fixe Position haben. Deshalb werden die GMR-Sensor-Chips entlang einer Kante direkt auf dem Permanentmagneten fixiert. Durch die Anordnung entlang einer Kante wird die grösste Annäherung der GMR-Sensor-Chips an das zu detektierende, weichmagnetische Element erreicht. Die Oberfläche des genannten Magneten und die schmalen Stirnseiten der GMR-Sensor-Chips liegen so in einer Ebene, und sie bilden die Oberfläche des gesamten Messkopfes welcher normalerweise mit einer (möglichst dünnen) nicht weichmagnetischen Gehäusewand gegen äussere mechanische Einflüsse geschützt werden muss.

Bei einer quaderförmigen Ausführung eines Permanentmagneten wird das zu detektierende weichmagnetische Element am besten entlang einer Längs- oder Querachse 7 geführt. Falls sich für eine bestimmte Geometrie einer Anwendung Vorteile ergeben, wäre aber auch eine Produktführung in einem geneigten Winkel zur Achse denkbar.

Bei der Qualitätskontrolle von Heftklammern sind folgende Aspekte von Wichtigkeit: Die Gehäuseform, welche einem Giebeldach (Siehe Fig. 1) ähnlich sieht, ist durch die geometrische Form des Abtransportes nach dem Heftkopf gegeben. Es wurde eine lange schlanke Quaderform für den Permanentmagneten ausgewählt, damit dieser sich optimal in diese Giebeldach-Kontur einbetten lässt, bzw. damit das ganze Messsystem möglichst dicht unter der Gehäuseoberfläche zu liegen kommt, um damit möglichst nahe an die Heftklammer zu kommen. Es werden zwei GMR-Sensor-Chips jeweils in der Mitte der Längskante angebracht. Diese Anordnung macht Sinn, weil die Heftklammer, welche entlang der Längsachse über den Messkopf geführt wird, als Messobjekt ein symmetrisches Gebilde ist. Mit nur einem seitlichen Sensor-Chip wäre in diesem Fall auch keine vernünftige Abbildung möglich.

Wesentlich für den Erfolg des Verfahrens ist die präzise Führung des Messobjektes. Die Heftklammern sollten immer in der Mitte des Heftkopfes und entlang dessen Oberfläche geführt werden. Variationen im Abstand zum Heftkopf sind für die Messung kritisch. Diese Rahmenbedingungen sind aber auch beim induktiven Verfahren entscheidend, so dass diese Basis als vorausgesetzt gelten kann.

## Patentansprüche

1. Verfahren für die durchlaufende Qualitätskontrolle eines applizierten Elementes hinsichtlich der geometrischen, strukturellen, funktionellen Parameter beim applizierten Element und zwischen diesem und dem Basisprodukt, wobei diese Qualitätskontrolle mit mindestens einer Messeinrichtung durchgeführt wird, **dadurch gekennzeichnet, dass** die Messeinrichtung im Wesentlichen aus mindestens einem Messkopf (2) gebildet wird, der aus mindestens einem Permanentmagneten (3) und aus mindestens einem GMR-Sensor-Chip (4a, 4b, 4c) besteht, mit welchem Messkopf eine Messung oder Detektierung des applizierten Elementes (6) vorgenommen wird, und daraus eine magnetisch basierte Abbildung dieses Elementes erzeugt wird.

2. Verfahren für die durchlaufende Qualitätskontrolle eines applizierten Elementes hinsichtlich der geometrischen, strukturellen, funktionellen Parameter beim applizierten Element und zwischen diesem und dem Basisprodukt, wobei diese Qualitätskontrolle mit mindestens einer Messeinrichtung durchgeführt wird, **dadurch gekennzeichnet, dass** das applizierte Element eine Heftklammer (6) und/oder eine Ösenheftklammer und das Basisprodukt ein Druckerzeugnis ist, dass die Messeinrichtung im Wesentlichen aus mindestens einem Messkopf (2) gebildet wird, der aus mindestens einem Permanentmagneten (3) und aus mindestens einem GMR-Sensor-Chip (4a, 4b, 4c) besteht, mit welchem Messkopf eine Detektierung der applizierten Klammer vorgenommen wird, und daraus eine magnetisch basierte Abbildung dieser Klammer erzeugt wird.

3. Verfahren nach einem der vorangehenden Ansprüche, **dadurch gekennzeichnet, dass** der Permanentmagnet eine magnetische Anregung auf das dort vorbeigeführte Element erzeugt, dass das weichmagnetische Element reaktiv selbst ein Magnetfeld erzeugt, das dem konstanten Feld des Permanentmagneten überlagert wird, dergestalt, dass mindestens ein GMR-Sensor-Chip die Feldstärken-Differenz an zwei nahe beieinander liegenden Punkten misst und dabei ein entsprechendes analoges Spannungssignal und daraus Rückschlüsse auf die Form des magnetischen Feldes liefert, und dass eine Abweichungen im Signalverlauf eine Information der geometrischen, strukturellen und funktionellen Parameter des applizierten Elementes darstellt.

4. Verfahren nach einem der Ansprüche 1-3, **dadurch gekennzeichnet, dass** bei asymmetrischem Durchlauf des zu messenden Elementes oder der zu detektierenden Heftklammer eine mathematische Auswertung erfolgt.

5. Verfahren nach einem der Ansprüche 3 und 4, **dadurch gekennzeichnet, dass** das erfasste Abbild aus dem Ist-Zustand des applizierten Elementes mit dem Referenz-Abbild gemäss Soll-Zustand verglichen wird, und durch die Auswertung mindestens einer Abweichung eine Gut/Schlecht-Auswertung vorgenommen wird.

6. Messeinrichtung für die Durchführung des Verfahrens nach einem der Ansprüche 1 oder 2, **dadurch gekennzeichnet, dass** die Messeinrichtung im Wesentlichen aus mindestens einem Messkopf (2) besteht, der im Wesentlichen aus mindestens einem Permanentmagneten (3) und aus mindestens einem GMR-Sensor-Chip (4a, 4b, 4c) besteht, dass beidseitig in Längsrichtung des Permanentmagneten (3) GMR-Sensor-Chips (4a, 4b, 4c) angeordnet sind, welche entlang der Länge der Ausdehnungsstrecke des Permanentmagneten und/oder entlang der Durchlaufstrecke (7) des Elementes oder der Heftklammer (6) symmetrisch oder asymmetrisch zueinander angeordnet sind.

7. Messeinrichtung nach Anspruch 6, **dadurch gekennzeichnet, dass** die GMR-Sensor Chips quer zur Durchlaufstrecke des Elementes oder der Heftklammer angeordnet sind.

8. Messeinrichtung nach einem der Ansprüche 6, 7, **dadurch gekennzeichnet, dass** auf jeder Seite des Permanentmagneten die Anzahl der GMR-Sensor-Chips verschieden gross ist

9. Messeinrichtung nach einem der Ansprüche 6, 7, **dadurch gekennzeichnet, dass** der Zwischenabstand der GMR-Sensor-Chips zueinander in Längsrichtung des Permanentmagneten verschieden gross ist.

10. Messeinrichtung nach einem der Ansprüche 6, 7, **dadurch gekennzeichnet, dass** mindestens zwei zueinander entgegengesetzt angeordnete GMR-Sensor-Chips eine komplementäre Messung oder Detektierungen vornehmen.

11. Messeinrichtung nach einem der Ansprüche 6, 7, **dadurch gekennzeichnet, dass** ein GMR-Sensor-Chip mehrere Messpunkte (4.1, 4.2) aufweist.

12. Messeinrichtung nach einem der 6-11, **dadurch gekennzeichnet, dass** die GMR-Sensor-Chips in Verbund mit dem Permanentmagneten die obere oder annähernd die oberste Ebene des Messkopfes bilden.

## Claims

1. A method for the continuous quality control of an applied element with regard to the geometric, structural and functional parameters of the applied element and between said applied element and the base product, this quality control being performed by means of at least one measuring device, **characterized in that** the measuring device essentially consists of at least one measuring head (2), which comprises at least one permanent magnet (3) and at least one GMR sensor chip (4a, 4b, 4c), said measuring head measuring or detecting the applied element (6), and a magnetic-based image of this element being generated as a result.

2. A method for the continuous quality control of an applied element with regard to the geometric, structural and functional parameters of the applied element and between said applied element and the base product, this quality control being performed by means of at least one measuring device, **characterized in that** the applied element is a staple (6) and/or an eyelet staple and the base product is a printed product, **in that** the measuring device essentially consists of at least one measuring head (2), which comprises at least one permanent magnet (3) and at least one GMR sensor chip (4a, 4b, 4c), said measuring head detecting the applied staple, and a magnetic-based image of this staple being generated as a result.

3. A method according to one of the preceding claims, **characterized in that** the permanent magnet generates a magnetic excitation on the element guided past it, **in that** the soft-magnetic element itself reactively generates a magnetic field, which is superimposed on the constant field of the permanent magnet in such a way that at least one GMR sensor chip measures the difference in field strength at two points located close to one another and delivers a corresponding analogue voltage signal, thus providing feedback with regard to the shape of the magnetic field, and **in that** a deviation in the signal curve represents an item of information relating to the geometric, structural and functional parameters of the applied element.

4. A method according to one of Claims 1 to 3, **characterized in that** a mathematical evaluation takes place if the element to be measured or the staple to be detected passes by asymmetrically.

5. A method according to one of Claims 3 or 4, **characterized in that** the acquired image of the actual state of the applied element is compared with the reference image representing the desired state and, by evaluating at least one deviation, a Good/Poor evaluation is made.

6. A measuring device for carrying out the method according to one of Claims 1 or 2, **characterized in that** the measuring device essentially consists of at least one measuring head (2), which essentially comprises at least one permanent magnet (3) and at least one GMR sensor chip (4a, 4b, 4c), **in that** GMR sensor chips (4a, 4b, 4c) are provided on both sides in longitudinal direction of the permanent magnet (3) and are disposed, symmetrically or asymmetrically relative to one another, along the longitudinal extent of the permanent magnet and/or along the section (7) through which the element or staple (6) passes.

7. A measuring device according to Claim 6, **characterized in that** the GMR sensor chips are disposed perpendicular to the section through which the element or staple passes.

8. A measuring device according to one of Claims 6 or 7, **characterized in that** the number of GMR sensor chips is different on each side of the permanent magnet.

9. A measuring device according to one of Claims 6 or 7, **characterized in that** the relative intervals between the GMR sensor chips in longitudinal direction of the permanent magnet are different.

10. A measuring device according to one of Claims 6 or 7, **characterized in that** at least two GMR sensor chips located opposite one another carry out a complementary measurement or detection.

11. A measuring device according to one of Claims 6 or 7, **characterized in that** a GMR sensor chip has a number of measuring points (4.1, 4.2).

12. A measuring device according to one of Claims 6 to 11, **characterized in that** the GMR sensor chips together with the permanent magnet form the upper or virtually uppermost plane of the measuring head.

## Revendications

1. Procédé de contrôle en continu de la qualité d'un élément appliqué quant aux paramètres géométriques, structurels et fonctionnels pour l'élément appliqué et entre celui-ci et le produit de base, sachant que ce contrôle de qualité est effectué avec au moins un dispositif de mesure, **caractérisé en ce que** le dispositif de mesure est formé pour l'essentiel d'au moins une tête de mesure (2), qui est constituée d'au moins un aimant permanent (3) et d'au moins une puce de capteur GMR (4a, 4b, 4c), tête de mesure au moyen de laquelle on entreprend une mesure ou une détection de l'élément appliqué (6), à partir de quoi l'on produit une reproduction à base magnétique de cet élément.

2. Procédé de contrôle en continu de la qualité d'un élément appliqué quant aux paramètres géométriques, structurels et fonctionnels pour l'élément appliqué et entre celui-ci et le produit de base, sachant que ce contrôle de qualité est effectué avec au moins un dispositif de mesure, **caractérisé en ce que** l'élément appliqué est une agrafe (6) et/ou une agrafe à oeillet et le produit de base est un produit imprimé, et **en ce que** le dispositif de mesure est formé pour l'essentiel d'au moins une tête de mesure (2), qui est constituée d'au moins un aimant permanent (3) et d'au moins une puce de capteur GMR (4a, 4b, 4c), tête de mesure au moyen de laquelle on entreprend une détection de l'agrafe appliquée, à partir de quoi l'on produit une reproduction à base magnétique de cette agrafe.

3. Procédé selon l'une des revendications précédentes, **caractérisé en ce que** l'aimant permanent produit une excitation magnétique sur l'élément passant devant lui, **en ce que** l'élément, magnétique doux, produit lui-même de manière réactive un champ magnétique qui est superposé au champ constant de l'aimant permanent, de telle sorte qu'au moins une puce de capteur GMR mesure la différence d'intensités de champ en deux points situés à proximité l'un de l'autre et délivre un signal de tension analogique correspondant et par suite des conclusions sur la forme du champ magnétique, et **en ce qu'**un écart dans l'allure du signal constitue une information sur les paramètres géométriques, structurels et fonctionnels de l'élément appliqué.

4. Procédé selon l'une des revendications 1 à 3, **caractérisé en ce qu'**en cas de passage asymétrique de l'élément à mesurer ou de l'agrafe à détecter, on effectue une évaluation mathématique.

5. Procédé selon l'une des revendications 3 et 4, **caractérisé en ce que** l'image enregistrée, provenant de l'état réel de l'élément appliqué, est comparée à l'image de référence selon l'état de consigne et, par l'évaluation d'au moins un écart, on entreprend une évaluation correct/incorrect.

6. Dispositif de mesure pour la mise en oeuvre du procédé selon l'une des revendications 1 ou 2, **caractérisé en ce que** le dispositif de mesure est constitué pour l'essentiel d'au moins une tête de mesure (2), qui est constituée d'au moins un aimant permanent (3) et d'au moins une puce de capteur GMR (4a, 4b, 4c), et **en ce que** des puces de capteur GMR (4a, 4b, 4c) sont disposées des deux côtés dans la direction longitudinale de l'aimant permanent (3), puces qui sont disposées symétriquement ou asymétriquement l'une par rapport à l'autre le long de la longueur du parcours d'étendue de l'aimant permanent et/ou le long du parcours de passage (7) de l'élément ou de l'agrafe (6).

7. Dispositif de mesure selon la revendication 6, **caractérisé en ce que** les puces de capteur GMR sont disposées transversalement au parcours de passage de l'élément ou de l'agrafe.

8. Dispositif de mesure selon l'une des revendications 6, 7, **caractérisé en ce que** le nombre de puces de capteur GMR est différent sur chaque côté de l'aimant permanent.

9. Dispositif de mesure selon l'une des revendications 6, 7, **caractérisé en ce que** l'espacement entre les puces de capteur GMR varie dans la direction longitudinale de l'aimant permanent.

10. Dispositif de mesure selon l'une des revendications 6, 7, **caractérisé en ce qu'**au moins deux puces de capteur GMR disposées opposées l'une à l'autre entreprennent une mesure ou une détection complémentaire.

11. Dispositif de mesure selon l'une des revendications 6, 7, **caractérisé en ce qu'**une puce de capteur GMR présente plusieurs points de mesure (4.1, 4.2).

12. Dispositif de mesure selon l'une des revendications 6 à 11, **caractérisé en ce que** les puces de capteur GMR forment, conjointement avec l'aimant permanent, le plan supérieur ou approximativement le plan le plus haut de la tête de mesure.
